(19) Europäisches Patentamt
European Patent Office
Office européen des brevets

(11) **EP 1 783 748 A1**

(12) **EUROPEAN PATENT APPLICATION**

(43) Date of publication:
**09.05.2007 Bulletin 2007/19**

(51) Int Cl.:
*G11B 5/73* (2006.01)   *G11B 5/84* (2006.01)
*C23C 14/34* (2006.01)

(21) Application number: **06251476.5**

(22) Date of filing: **20.03.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **02.11.2005 US 264137**

(71) Applicant: **Heraeus, Inc.**
**Chandler AZ 85226 (US)**

(72) Inventors:
• **Das, Anirban**
**Tempe**
**AZ 85283 (US)**
• **Racine, Michael Gene**
**Phoenix**
**AZ 85044 (US)**

(74) Representative: **Hill, Justin John et al**
**McDermott Will & Emery UK LLP**
**7 Bishopsgate**
**London EC2N 3AR (GB)**

(54) **Deposition of enhanced seed layer using tantalum alloy based sputter target**

(57)    A seedlayer for a magnetic recording medium, the seedlayer formed over a substrate from a sputter target comprised of tantalum (Ta) and an alloying element. The solubility of the alloying element in a body centered cubic tantalum (Ta) phase does not exceed 10 atomic percent at room temperature, and the alloying element has a mass susceptibility of less than or equal to $1.5 \times 10^{-7} \frac{m^3}{kg}$, where possible alloying elements include (but are not limited to) boron (B), carbon (C), aluminum (Al), silicon (Si), titanium (Ti), vanadium (V), manganese (Mn), chromium (Cr), zirconium (Zr), niobium (Nb), molybdenum (Mo), ytterbium (Yb), lutetium (Lu), hafnium (Hf), bismuth (Bi), and tungsten (W). Alternatively, the alloying element is soluble in tantalum (Ta) at room temperature or at elevated temperatures, has a mass susceptibility of less than or equal to $1.5 \times 10^{-7} \frac{m^3}{kg}$, and has an atomic radius smaller than 1.47Å, where possible alloying elements include (but are not limited to) boron (B), carbon (C), aluminum (Al), silicon (Si), chromium (Cr), ruthenium (Ru), rhodium (Rh), rhenium (Re), iridium (Ir) and platinum (Pt). Further alternatively, the solubility of the alloying element in a body centered cubic tantalum (Ta) phase does not exceed 10 atomic percent at room temperature, and the alloying element has a mass susceptibility of less than or equal to $1.5 \times 10^{-7} \frac{m^3}{kg}$, is soluble in tantalum (Ta) at temperatures higher than room temperature, and has an atomic radius smaller than 1.47Å, where possible elements include (but are not limited to boron (B), carbon (C), aluminum (Al), silicon(Si), platinum (Pt), and chromium (Cr).

**Description**

BACKGROUND OF THE INVENTION

FIELD OF THE INVENTION

The present invention generally relates to sputter targets and, more particularly, relates to the deposition of a seedlayer for a magnetic recording medium used for perpendicular magnetic recording ("PMR") applications, where the seedlayer provides for grain size refinement and reduced lattice mis-fit for a subsequently deposited underlayer and/or granular magnetic layer, and where the seedlayer is deposited using a tantalum (Ta) alloy based sputter target.

DESCRIPTION OF THE RELATED ART

The process of direct current ("DC") magnetron sputtering is widely used in a variety of fields to provide thin film material deposition of a precisely controlled thickness and within narrow atomic fraction tolerances on a substrate, for example to coat semiconductors and/or to form films on surfaces of magnetic recording media. In one common configuration, a racetrack-shaped magnetic field is applied to the sputter target by placing magnets on the backside surface of the target. Electrons are trapped near the sputtering target, improving argon ion production and increasing the sputtering rate. Ions within this plasma collide with a surface of the sputter target causing the sputter target to emit atoms from the sputter target surface. The voltage difference between the cathodic sputter target and an anodic substrate that is to be coated causes the emitted atoms to form the desired film on the surface of the substrate.

Other common approaches to sputtering include conventional co-sputtering, and co-sputtering using a triatron. In the co-sputtering process, multiple independent sputter targets with independent power supplies are positioned within the vacuum chamber and sputtered simultaneously, where the uniformity of the deposited surface is controlled by selectively sputtering one or more of the multiple sputter targets. To sputter a $X_1$-$X_2$ thin film using conventional co-sputtering, for example, a sputter target comprised of $X_1$ would be placed in the vacuum chamber with a sputter target comprised of $X_2$, and sputtering would occur on both sputter targets simultaneously. Triatron configuration co-sputtering, on the other hand, uses a single sputter target with multiple independent regions of composition. Adapting the above example to a triatron configuration, a single triatron sputter target would have an region comprised solely of $X_1$ and a region comprised solely of $X_2$, where both regions would be co-sputtered simultaneously to deposit an $X_1$-$X_2$ thin film.

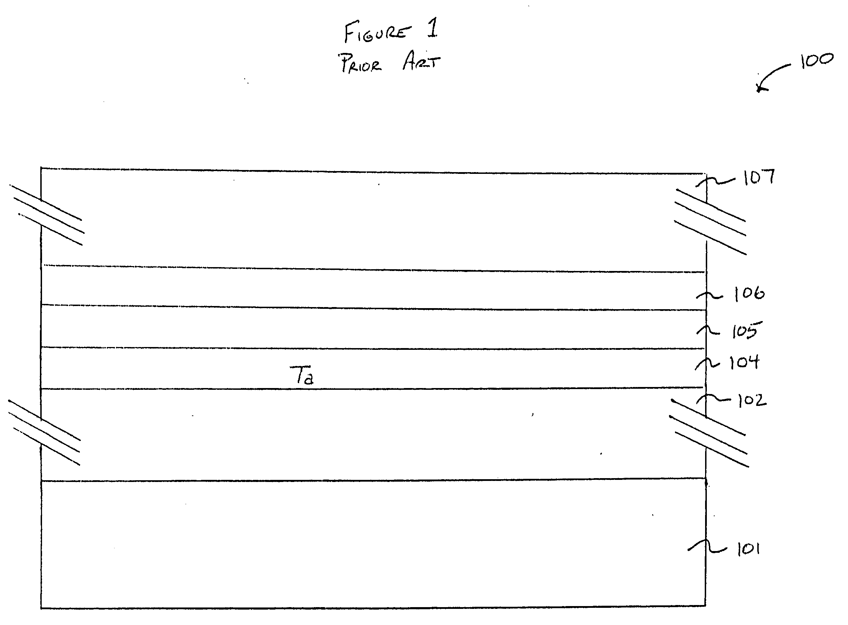

During the production of conventional magnetic recording media, layers of thin films are sequentially sputtered onto a substrate by multiple sputter targets, where each sputter target is comprised of a different material, resulting in the deposition of a thin film "stack." Figure 1 illustrates typical thin film stack 100 for conventional magnetic recording media. At the base of stack 100 is non-magnetic substrate 101, which is typically aluminum or glass. Seed layer 104 is deposited over substrate 101, where seedlayer 104 forces the shape and orientation of the grain structure of higher layers, and is commonly comprised of tantalum (Ta). Magnetic and/or non-magnetic layers 102 may optionally be deposited between substrate 101 and seedlayer 104, where layers 102 may include additional underlayers, anti-ferromagnetic layers, or other types of layers.

Next, underlayer 105, which often includes one to three discrete layers, is deposited over seedlayer 104, where underlayer 105 is typically very weakly-magnetic, crystalline, and hexagonal close-packed ("HCP"). Underlayer 105 is used to enhance the Co (0002) texture of the subsequently-deposited, cobalt (Co)-based magnetic data-storing granular layer 106 perpendicular to the film plane, leading to a increased perpendicular anisotropy of the media. Magnetic data-storing granular layer 106 is subsequently deposited over underlayer 105, and optional additional layers 107, such as a lubricant layer or carbon (C) overcoat, are deposited over granular layer 106.

Underlayer 105 enhances the crystallographic texturing of the subsequently deposited magnetic data-storing granular layer 106. Furthermore, if magnetic data-storing granular layer 106 is grown epitaxially on top of a refined grain sized, crystalline underlayer, the grain size of magnetic data-storing granular layer 106 is refined as well. Additionally, close lattice matching between underlayer 105 and magnetic data-storing granular layer 106 provides a substantially defect-free interface, potentially reducing contribution to any in-plane magnetization.

The amount of data that can be stored per unit area on a magnetic recording medium is directly related to the metallurgical characteristics and the composition of the magnetic data-storing granular layer and, correspondingly, to the sputter target material from which the magnetic data-storing granular layer is sputtered. In recent years, the magnetic data storage industry has pursued a technology known as 'PMR' (as opposed to conventional 'longitudinal magnetic recording' ("LMR")) to sustain the demand for continuous growth in data storage capacity. PMR has a higher write efficiency using a perpendicular single-pole recording head in combination with a soft underlayer, where bits are recorded perpendicular to the plane of the magnetic recording medium, allowing for a smaller bit size and greater coercivity. In the future, PMR is expected to increase disk coercivity and strengthen disk signal amplitude, translating into superior archival data retention.

In order to achieve a high recording density in PMR media, thermal stability should be high, and media noise performance should be low. One approach to realizing the essential thermal stability and media noise requirements in PMR media is to provide a granular magnetic media with magnetic domains having high magnetocrystalline anisotropy ($K_u$), and to adequately encapsulate a fine grain microstructure in a structurally, magnetically and electrically insulating matrix. Although significant anisotropic energy is already required by conventional LMR, PMR requires a much finer grain microstructure with adequate grain-to grain segregation and negligible cross-talk between the magnetic domains, in order to achieve low media noise performance and high thermal stability.

The inclusion of an oxygen-rich grain boundary region has significantly improved grain refinement and has provided excellent microstructural, magnetic and electrical isolation. In this regard, oxygen (O)-containing magnetic data storing layer 106 often includes at least one CoCrPt-based alloy layer, since oxygen (O) in the grain boundary region forms an amorphous, hard and brittle grain boundary region which confines the grain growth and helps refine the grain size of these oxide-containing granular layers. Other high or low moment CoPt(Cr)(B)-based magnetic data storing layers are also commonly subsequently deposited on this CoCrPt-based granular magnetic layer in order to adjust the saturation magnetization ($M_s$) commensurate with specified disk head design.

It is therefore considered highly desirable to improve upon known sputter target alloys and compositions, to provide for the deposition of a magnetic data-storing granular layer with greater data-storage potential, with particular regard to magnetic data-storing granular layers used in PMR. Specifically, it is highly desirable to provide a sputter target which, when sputtered as a seedlayer, provides increased crystallinity and further grain size refinement to a subsequently deposited underlayer and/or magnetic data-storing granular layer.

### SUMMARY OF THE INVENTION

The present invention generally relates to sputter targets and, more particularly, relates to the deposition of a seedlayer for a magnetic recording medium used for PMR applications, where the seedlayer provides for grain size refinement and reduced lattice mis-fit for a subsequently deposited underlayer and/or granular magnetic layer, and where the seedlayer is deposited using a tantalum (Ta) alloy based sputter target.

According to a first arrangement, the present invention is a magnetic recording medium, including a substrate and a seedlayer deposited over the substrate, the seedlayer comprised of tantalum (Ta) and an alloying element. The magnetic recording medium also includes an underlayer deposited over the seedlayer, and a magnetic data-storing granular layer deposited over the underlayer. The solubility of the alloying element in a body centered cubic tantalum (Ta) phase does not exceed 10 atomic percent at room temperature, and the alloying element has a mass susceptibility of less than or equal to $1.5 \times 10^{-7} \ \dfrac{m^3}{kg}$.

The alloying element promotes grain size refinement in the crystalline seedlayer. Just as the refined grain size of the crystalline underlayer helps reduce the grain size reduction of the subsequently deposited granular magnetic layer, a similar effect is realized by the underlayer if the underlayer is subsequently deposited epitaxially on top of the reduced grain size, crystalline tantalum (Ta) alloy based seedlayer. The present invention provides for a promotion of grain size refinement by alloying substantially pure tantalum (Ta) with an element which acts as grain size refiner in the crystalline tantalum (Ta) alloy based seedlayer film, so the alloying element has little or no solubility in the body centered cubic ("BCC") tantalum (Ta) phase at room temperature, such that the alloying element forms the amorphous grain boundary in the tantalum (Ta) alloy based seedlayer film and help in grain size reduction by confming further grain growth during processing.

The alloying element is selected from boron (B), carbon (C), aluminum (Al), silicon (Si), titanium (Ti), vanadium (V), manganese (Mn), chromium (Cr), zirconium (Zr), niobium (Nb), molybdenum (Mo), ytterbium (Yb), lutetium (Lu), hafnium (Hf), bismuth (Bi), and tungsten (W).

According to a second arrangement, the present invention is a magnetic recording medium, including a substrate and a seedlayer deposited over the substrate, the seedlayer comprised of tantalum (Ta) and an alloying element. The magnetic recording medium also includes an underlayer deposited over the seedlayer, and a magnetic data-storing granular layer deposited over the underlayer. The alloying element is soluble in tantalum (Ta) at room temperature or at elevated temperatures, has a mass susceptibility of less than or equal to $1.5 \times 10^{-7} \ \dfrac{m^3}{kg}$, and has an atomic radius smaller than 1.47Å.

Due to the symmetry of the BCC (110) plane with the HCP (0002) plane of ruthenium (Ru), the present invention provides for the reduction of lattice mis-fit of crystalline underlayers, such as ruthenium (Ru) or ruthenium (Ru)-based underlayers or underlayers composed of different base metals, and tantalum (Ta) alloy based seedlayers by alloying the crystalline seedlayer with tantalum (Ta) and elements which are soluble in tantalum (Ta) at room temperature or at higher temperatures. These alloying elements form solid solutions with tantalum (Ta) at room temperature or at elevated temperatures, and thus accordingly modify the in-plane lattice parameter of tantalum (Ta), thereby reducing the lattice mis-fit. The alloying element in the tantalum (Ta)-alloy based has some solid solubility in tantalum (Ta) at room temperature or at elevated temperatures, so that the alloying element forms a substitutional solid solution with tantalum (Ta) and affects its in-plane, a-lattice parameter. Additionally, the alloying element is non-magnetic or weakly-magnetic in nature, with a mass susceptibility of less than or equal to $1.5 \times 10^{-7} \frac{m^3}{kg}$. Since the in-plane lattice parameter for tantalum (Ta) is higher than that of ruthenium (Ru), the alloying element has an atomic radius smaller than that of 1.47Å, which is the atomic radius of tantalum (Ta).

The alloying element is selected from boron (B), carbon (C), aluminum (Al), silicon (Si), chromium (Cr), ruthenium (Ru), rhodium (Rh), rhenium (Re), iridium (Ir) and platinum (Pt). In one example, the underlayer is comprised of ruthenium (Ru) or a ruthenium (Ru)-based alloy, the underlayer can be comprised of other base metals or elements as well.

According to a third arrangement, the present invention is a magnetic recording medium, including a substrate and a seedlayer deposited over the substrate, the seedlayer comprised of tantalum (Ta) and an alloying element. The magnetic recording medium also includes an underlayer deposited over the seedlayer, and a magnetic data-storing granular layer deposited over the underlayer. The solubility of the alloying element in a body centered cubic tantalum (Ta) phase does not exceed 10 atomic percent at room temperature, and the alloying element has a mass susceptibility of less than or equal to $1.5 \times 10^{-7} \frac{m^3}{kg}$, is soluble in tantalum (Ta) at temperatures higher than room temperature, and has an atomic radius smaller than 1.47Å.

Accordingly, by utilizing an alloying element which forms an amorphous grain boundary in the tantalum (Ta) alloy, and which enhances crystallinity, the present invention provides for a tantalum (Ta) alloy seedlayer which acts as both a grain refiner for subsequently deposited layers, and lattice mis-fit reducer for eliminating residual interface stresses.

The alloying element is selected from boron (B), carbon (C), aluminum (Al), silicon(Si), platinum (Pt), and chromium (Cr).

According to a fourth arrangement, the present invention is a method of manufacturing a magnetic recording medium, including the step of sputtering at least a first seedlayer over a substrate from a first sputter target, where the sputter target is comprised of tantalum (Ta) and an alloying element. The solubility of the alloying element in a body centered cubic tantalum (Ta) phase does not exceed 10 atomic percent at room temperature, and the alloying element has a mass susceptibility of less than or equal to $1.5 \times 10^{-7} \frac{m^3}{kg}$. The method also includes the steps of sputtering at least a first underlayer over the first seedlayer from a second sputter target, and sputtering at least a first magnetic data-storing granular layer over the first underlayer from a third sputter target.

The first seedlayer, the first underlayer and/or the first magnetic data-storing granular layer are sputtered using a co-sputtering process or assembly, or using a triatron configuration.

According to an fifth arrangement, the present invention is a method of manufacturing a magnetic recording medium, including the step of sputtering at least a first seedlayer over a substrate from a first sputter target, where the first sputter target is comprised of tantalum (Ta) and an alloying element, wherein the alloying element is soluble in tantalum (Ta) at room temperature or at elevated temperatures, has a mass susceptibility of less than or equal to $1.5 \times 10^{-7} \frac{m^3}{kg}$, and has an atomic radius smaller than 1.47Å. The method also includes the steps of sputtering at least a first underlayer over the first seedlayer from a second sputter target, and sputtering at least a first magnetic data-storing granular layer over the first underlayer from a third sputter target.

According to a sixth arrangement, the present invention is a method of manufacturing a magnetic recording medium, including the step of sputtering at least a first seedlayer over a substrate from a first sputter target, where the first sputter target is comprised of tantalum (Ta) and an alloying element. The solubility of the alloying element in a body centered cubic tantalum (Ta) phase does not exceed 10 atomic percent at room temperature, and the alloying element has a mass susceptibility of less than or equal to $1.5 \times 10^{-7} \frac{m^3}{kg}$, is soluble in tantalum (Ta) at temperatures higher than room temperature, and has an atomic radius smaller than 1.47Å. The method also includes the steps of sputtering at least a first underlayer over the first seedlayer from a second sputter target, and sputtering at least a first magnetic data-storing granular layer over the first underlayer from a third sputter target.

According to a seventh arrangement, the present invention is a sputter target, where the sputter target is comprised of tantalum (Ta) and an alloying element. The solubility of the alloying element in a body centered cubic tantalum (Ta) phase does not exceed 10 atomic percent at room temperature, and the alloying element has a mass susceptibility of less than or equal to $1.5 \times 10^{-7} \frac{m^3}{kg}$.

The alloying element is selected from boron (B), carbon (C), titanium (Ti), vanadium (V), manganese (Mn), chromium (Cr), zirconium (Zr), niobium (Nb), molybdenum (Mo), ytterbium (Yb), lutetium (Lu), hafnium (Hf), bismuth (Bi), and tungsten (W).

According to an eighth arrangement, the present invention is a sputter target, where the sputter target is comprised of tantalum (Ta) and an alloying element. The alloying element is soluble in tantalum (Ta) at room temperature or at elevated temperatures, has a mass susceptibility of less than or equal to $1.5 \times 10^{-7} \frac{m^3}{kg}$, and has an atomic radius smaller than 1.47Å.

The alloying element is selected from boron (B), carbon (C), chromium (Cr), ruthenium (Ru), rhodium (Rh), rhenium (Re), iridium (Ir) and platinum (Pt).

According to a ninth arrangement, the present invention is a sputter target, where the sputter target is comprised of tantalum (Ta) and an alloying element. The solubility of the alloying element in a body centered cubic tantalum (Ta) phase does not exceed 10 atomic percent at room temperature, and the alloying element has a mass susceptibility of less than or equal to $1.5 \times 10^{-7} \frac{m^3}{kg}$, is soluble in tantalum (Ta) at temperatures higher than room temperature, and has an atomic radius smaller than 1.47Å.

The alloying element is selected from boron (B), carbon (C), platinum (Pt), and chromium (Cr).

According to a tenth arrangement, the present invention is a sputter target for triatron configuration sputtering, including a first region comprised of tantalum (Ta) and a second region comprised of an alloying element. The solubility of the alloying element in a body centered cubic tantalum (Ta) phase does not exceed 10 atomic percent at room temperature, and the alloying element has a mass susceptibility of less than or equal to $1.5 \times 10^{-7} \frac{m^3}{kg}$.

According to an eleventh arrangement, the present invention is a sputter target for triatron configuration sputtering, including a first region comprised of tantalum (Ta) and a second region comprised of an alloying element. The alloying element is soluble in tantalum (Ta) at room temperature or at elevated temperatures, has a mass susceptibility of less than or equal to $1.5 \times 10^{-7} \frac{m^3}{kg}$, and has an atomic radius smaller than 1.47Å.

According to a twelfth arrangement, the present invention is a sputter target for triatron configuration sputtering, including a first region comprised of tantalum (Ta) and a second region comprised of an alloying element. The solubility of the alloying element in a body centered cubic tantalum (Ta) phase does not exceed 10 atomic percent at room temperature, and the alloying element has a mass susceptibility of less than or equal to $1.5 \times 10^{-7} \frac{m^3}{kg}$, is soluble in tantalum (Ta) at temperatures higher than room temperature, and has an atomic radius smaller than 1.47Å.

In the following description of the preferred embodiment, reference is made to the accompanying drawings that form a part thereof, and in which is shown by way of illustration a specific embodiment in which the invention may be practiced. It is to be understood that other embodiments may be utilized and changes may be made without departing from the scope of the present invention.

BRIEF DESCRIPTION OF THE DRAWINGS

Referring now to the drawings in which like reference numbers represent corresponding parts throughout:

Figure 1 depicts a typical thin film stack for conventional PMR media;

Figure 2 depicts a thin film stack in which seedlayer has been sputtered by a sputter target according to one embodiment of the present invention;

Figure 3 is an X-ray diffraction ("XRD") spectrum of a tantalum (Ta) film, which demonstrates that the present invention is capable of enhancing the crystallinity of a subsequently deposited the HCP underlayer, while reducing lattice mis-fit;

Figure 4 depicts the lattice mis-fit of substantially pure tantalum (Ta) and ruthenium (Ru) films;

Figure 5 is a flowchart depicting a method for manufacturing a magnetic recording medium, according to a second embodiment of the present invention; and

Figures 6A and 6B depict a top view and a cross-section view of a sputter target for a triatron configuration, respectively, according to a third embodiment of the present invention.

DETAILED DESCRIPTION OF THE INVENTION

The present invention provides for further grain size refinement in the underlayer and subsequently deposited magnetic data-storing granular layer, by depositing the underlayer on a crystalline tantalum (Ta) alloy based seedlayer. The tantalum (Ta) alloy based seedlayer includes components which act as grain size refiners, since the components have limited solubility in tantalum (Ta) at room temperature ("RT")(approximately 20-23 °C, or 68-73 °F), forming an amorphous grain boundary region which confines further grain growth of the tantalum (Ta) in the granular layer. Furthermore, the present invention provides for the reduction of the lattice mis-fit between the seedlayer and underlayer by alloying the tantalum (Ta) alloy based seed layer with elements soluble in tantalum (Ta) at room temperature and temperatures elevated from room temperature, so that residual stresses at the interface are minimized and crystallinity is enhanced.

Just as the refined grain size of the crystalline underlayer helps reduce the grain size reduction of the subsequently deposited granular magnetic layer, a similar effect is realized by the underlayer if the underlayer is subsequently deposited epitaxially on top of the reduced grain size, crystalline tantalum (Ta) alloy based seedlayer. Substantially pure tantalum (Ta) is alloyed with an alloying element which acts as grain size refiner in the crystalline tantalum (Ta) alloy based seedlayer film. The alloying element has little or no solubility in the BCC tantalum (Ta) phase at room temperature, such that the alloying element forms the amorphous grain boundary in the tantalum (Ta) alloy based seedlayer film and help in grain size reduction by confining further grain growth during processing.

The alloying element is non-magnetic or weakly magnetic in nature, with a mass susceptibility of less than or equal to $1.5 \times 10^{-7} \frac{m^3}{kg}$. Table 1, below, provides a list of alloying elements which can be alloyed with tantalum (Ta) to form an enhanced alloy which provides for grain size reduction in the seedlayer film, although other elements which meet these characteristics may also be used as well.

Table 1: Alloying elements which provide for grain size reduction in the seedlayer film.

| Element | Atomic Number | Atomic Radius | Crystal Structure | Mass susceptibilty (10^-8 m3/kg) | Room temperature solubility in tantalum (Ta) |
|---|---|---|---|---|---|
| B | 5 | 0.97 Å | rhombohedral | -0.87 | 2% (2092 °C), insoluble (RT) |
| C | 6 | 0.77 Å | diamond cubic | -0.62 | 7% (2843 °C); insoluble (RT) |
| Al | 13 | 1.43 Å | face centered cubic | 0.82 | 5% (2100°C), insoluble (RT) |
| Si | 14 | 1.17 Å | diamond cubic | -0.16 | 5%(2260°C); 1% (1000°C) |
| Ti | 22 | 1.47 Å | hexagonal | 4.21 | Insoluble(RT) |
| V | 23 | 1.36 Å | body centered cubic | 6.28 | Insoluble (RT) |
| Mn | 25 | 1.18 Å | cubic | 12.2 | Insoluble (RT) |
| Cr | 26 | 1.28 Å | body centered cubic | 4.45 | 27%(1965°C), 3% (1000°C) |

(continued)

| Element | Atomic Number | Atomic Radius | Crystal Structure | Mass susceptibilty (10^-8 m3/kg) | Room temperature solubility in tantalum (Ta) |
|---|---|---|---|---|---|
| Zr | 40 | 1.6 Å | hexagonal | 1.66 | Insoluble (RT) |
| Nb | 41 | 1.47 Å | body centered cubic | 2.81 | Insoluble (RT) |
| Mo | 42 | 1.4 Å | body centered cubic | 1.17 | Insoluble (RT) |
| Yb | 70 | 1.93 Å | face centered cubic | 0.59 | Insoluble |
| Lu | 71 | 1.73 Å | hexagonal | 0.12 | Insoluble |
| Hf | 72 | 1.59 Å | hexagonal | 0.53 | Insoluble |
| Bi | 83 | 1.75 Å | monoclinic | -1.7 | Insoluble |
| W | 74 | 1.41Å | body centered cubic | 0.39 | Insoluble |

The alloying element can be added in high atomic percentages, such as 50% in the tantalum (Ta) based alloy, although higher or lower atomic percentages can also be used, such as 1%, 5%, 15-25%, or 40-50%. The alloying element can also be added in excess of its maximum solubility limit, at room temperature or higher temperatures. "Higher" than room temperature or "elevated" over room temperature means any temperature over room temperature, which is ordinarily considered approximately 20-23 °C, or 68-73 °F. Example temperatures which would be higher than or elevated over room temperature would be 25 °C, 100 °C, 1000 °C, 2500 °C, or 5000 °C.

By alloying the tantalum (Ta)-based seed layer so that residual stresses at the interface are minimized and crystallinity is enhanced, the present invention provides for the reduction of the lattice mis-fit between the seedlayer and underlayer. The BCC (110) plane is the predominant crystallographic orientation of the approximately 30 nanometer tantalum (Ta) films deposited on the amorphous substrate under room temperature deposition conditions. Due to the symmetry of the BCC (110) plane with the HCP (0002) plane of ruthenium (Ru), the present invention provides for the reduction of lattice mis-fit of crystalline ruthenium (Ru) or ruthenium (Ru)-based underlayers and tantalum (Ta) alloy based seedlayers, by alloying the crystalline seedlayer with tantalum (Ta) and elements which are soluble in tantalum (Ta) at room temperature or at higher temperatures. These alloying elements form solid solutions with tantalum (Ta) at room temperature or at elevated temperatures, and thus accordingly modify the in-plane lattice parameter of tantalum (Ta), thereby reducing the lattice mis-fit.

The alloying element in the tantalum (Ta)-alloy based has some solid solubility in tantalum (Ta) at room temperature or at elevated temperatures, so that the alloying element forms a substitutional solid solution with tantalum (Ta) and affects its in-plane, a-lattice parameter. Additionally, the alloying element is non-magnetic or weakly-magnetic in nature, with a mass susceptibility of less than or equal to $1.5 \times 10^{-7} \frac{m^3}{kg}$. Since the in-plane lattice parameter for tantalum (Ta) is higher than that of ruthenium (Ru), the alloying element has an atomic radius smaller than that of 1.47Å, which is the atomic radius of tantalum (Ta). Based on the above criteria, Table 2 (below) provides a list of alloying elements which can be alloyed with tantalum (Ta) to form alloys which provide for potential lattice matching with the subsequently deposited underlayer, further enhancing crystallinity.

Table 2: Alloying elements which further enhance crystallinity & reduce lattice mis-fit.

|  | At No. | At.Radius | Crystal structure | Mass susceptibilty (10^-8 m3/kg) | Room temperature solubility in tantalum (Ta) |
|---|---|---|---|---|---|
| B | 5 | 0.97 Å | rhombohedral | -0.87 | 2% (2092 °C), insoluble (RT) |
| C | 6 | 0.77 Å | diamond cubic | -0.62 | 7% (2843° C); insoluble (RT) |

(continued)

| | At No. | At.Radius | Crystal structure | Mass susceptibilty (10^-8 m3/kg) | Room temperature solubility in tantalum (Ta) |
|---|---|---|---|---|---|
| Al | 13 | 1.43 Å | face centered cubic | 0.82 | 5% (2100°C), Insoluble (RT) |
| Si | 14 | 1.17 Å | diamond cubic | -0.16 | 5% (2260°C); 1% (1000 °C) |
| Cr | 24 | 1.28 Å | body centered cubic | 4.45 | 27% (1965 °C); 3% (1000°C) |
| Ru | 44 | 1.34 Å | hexagonal | 0.54 | 45% (1970°C); 42% (RT) |
| Rh | 45 | 1.34 Å | face centered cubic | 132 | 16% (2110°C); 8% (1000°C) |
| Re | 75 | 1.41 Å | hexagonal | 0.46 | 47.3% (2690 °C); 44% (2000°C) |
| Ir | 77 | 1.35 Å | face centered cubic | 023 | 7.3% (2479°C); 5% (1600°C) |
| Pt | 78 | 1.38 Å | face centered cubic | 1.22 | 9.5% (2470°C); 35% (500°C) |

The alloying element in the tantalum (Ta) alloy based seedlayer is added within the solubility range or in excess of the alloying element's high solubility limit for room temperature or above, in tantalum (Ta).

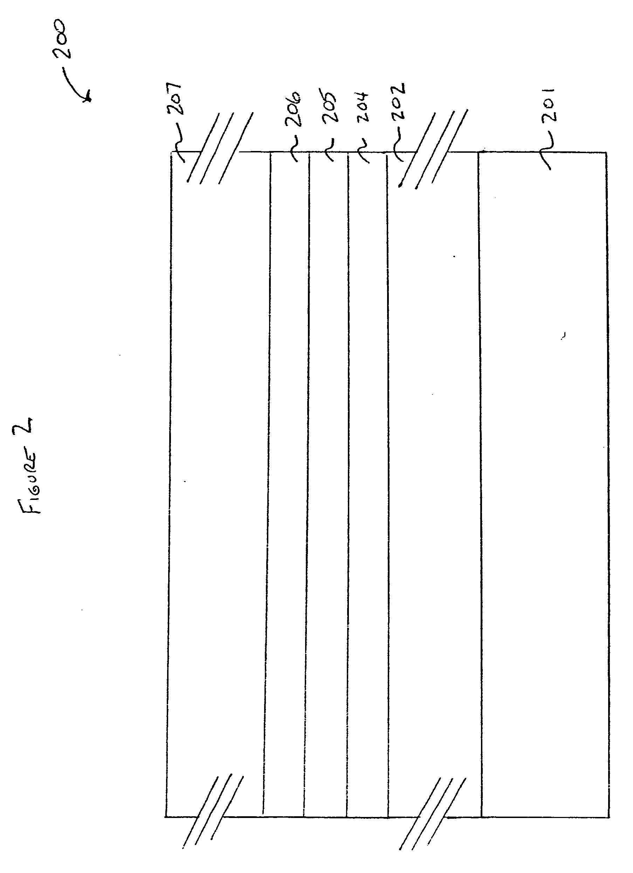

Figure 2 depicts a thin film stack in which seedlayer has been sputtered by a sputter target according to one embodiment of the present invention. Briefly, the magnetic recording medium includes a substrate and a seedlayer deposited over the substrate, the seedlayer comprised of tantalum (Ta) and an alloying element. The magnetic recording medium also includes an underlayer deposited over the seedlayer, and a magnetic data-storing granular layer deposited over the underlayer.

In more detail, magnetic recording medium 200 includes substrate 201 and seedlayer 204 deposited over the substrate, seedlayer 204 comprised of tantalum (Ta) and an alloying element. Layer 202, which includes one or more underlayer, anti-ferromagnetic layer, or other type of layer is deposited between substrate 201 and seedlayer 204, although in alternate aspects of the present invention layer 202 is omitted.

Magnetic recording medium 200 also includes underlayer 205 deposited over seedlayer 204, and magnetic data-storing granular layer 206 deposited over underlayer 205. Magnetic recording medium 200 also includes layer 207, which includes one or more layers such as a carbon (C) overcoat or a lubricant layers, although in alternate aspects layer 207 is omitted.

Underlayer 205 is comprised of ruthenium (Ru) or a ruthenium (Ru)-based alloy, although other base metals typically used in the art may be used in conjunction with or instead of ruthenium (Ru). In particular, nickel (Ni), terbium (Tb) or titanium (Ti) could also be used as an underlayer, as could any material with a HCP structure at room temperature.

According to one aspect associated with this arrangement, the solubility of the alloying element in a body centered cubic tantalum (Ta) phase does not exceed 10 atomic percent at room temperature, and the alloying element has a mass susceptibility of less than or equal to $1.5 \times 10^{-7} \frac{m^3}{kg}$. Elements which meet these parameters and which could be used as the alloying element include, but are not limited to, boron (B), carbon (C), aluminum (Al), silicon (Si), titanium (Ti), vanadium (V), manganese (Mn), chromium (Cr), zirconium (Zr), niobium (Nb), molybdenum (Mo), ytterbium (Yb), lutetium (Lu), hafnium (Hf), bismuth (Bi), and tungsten (W). Other alloying elements which meet the above criteria can be used as well, in conjunction with or instead of these listed elements.

As such, substantially pure tantalum (Ta) is alloyed with an alloying element, which acts as grain size refiner in the crystalline tantalum (Ta) alloy based seedlayer film. Since the alloying element has little or no solubility in the BCC tantalum (Ta) phase at room temperature, the alloying element forms the amorphous grain boundary in the tantalum (Ta) alloy based seedlayer film and aids in grain size reduction by confining further grain growth during processing.

According to a second, alternate aspect associated with this arrangement, the alloying element is soluble in tantalum (Ta) at room temperature or at elevated temperatures, has a mass susceptibility of less than or equal to

$$1.5 \times 10^{-7} \frac{m^3}{kg},$$ and has an atomic radius smaller than 1.47Å. Elements which meet these parameters and which could be used as the alloying element include, but are not limited to boron (B), carbon (C), aluminum (Al), silicon (Si), chromium (Cr), ruthenium (Ru), rhodium (Rh), rhenium (Re), iridium (Ir) and platinum (Pt). Other alloying elements which meet the above criteria can be used as well, in conjunction with or instead of these listed elements.

In this regard, lattice mis-fit between the seedlayer and underlayer is reduced by alloying the tantalum (Ta)-based seed layer, so that residual stresses at the interface are minimized and crystallinity is enhanced. The alloying element in the tantalum (Ta)-alloy based has some solid solubility in tantalum (Ta) at room temperature or at elevated temperatures, so that the alloying element forms a substitutional solid solution with tantalum (Ta) and affects its in-plane, a-lattice parameter.

According to a third, alternate aspect also associated with this arrangement, the solubility of the alloying element in a body centered cubic tantalum (Ta) phase does not exceed 10 atomic percent at room temperature, and the alloying element has a mass susceptibility of less than or equal to $1.5 \times 10^{-7} \dfrac{m^3}{kg}$, is soluble in tantalum (Ta) at temperatures higher than room temperature, and has an atomic radius smaller than 1.47Å. Elements which meet these parameters and which could be used as the alloying element include, but are not limited to boron (B), carbon (C), aluminum (Al), silicon(Si), platinum (Pt), and chromium (Cr). Other alloying elements which meet the above criteria can be used as well, in conjunction with or instead of these listed elements.

This particular aspect benefits from both the grain refinement and reduction of lattice mis-fit, as described in more detail above. Specifically, by utilizing an alloying element which forms an amorphous grain boundary in the tantalum (Ta) alloy based seedlayer film, and which enhances crystallinity, a tantalum (Ta) alloy is provided which acts as both a grain refiner for subsequently deposited layers, and lattice mis-fit reducer for the elimination of residual interface stresses.

The first seedlayer, the first underlayer and/or the first magnetic data-storing granular layer are sputtered using a co-sputtering assembly or process, or using a triatron. As indicated above, the co-sputtering process uses multiple independent sputter targets with independent power supplies which are contemporaneously positioned within the vacuum chamber controlled the uniformity of the sputtered surface by selectively sputtering one or more of the multiple sputter targets.

The present invention relates tantalum (Ta) alloy based seedlayers which are deposited in conjunction with an underlayer and/or a magnetic data-storing granular media layer, in magnetic media stacks used for PMR. The present invention provides for grain refinement of the underlayer by epitaxially depositing an underlayer on a tantalum (Ta) alloy based crystalline seedlayer, where the allying element of the tantalum (Ta) alloy acts as a grain size refined by forming an amorphous grain boundary region and confining further grain size growth, due to its limited solubility or insolubility in tantalum (Ta) at room temperature. Further, the present invention provides for the reduction of lattice mis-fit between the HCP based underlayer with the BCC tantalum (Ta)-alloy based seed layer, enhancing the crystallinity of the underlayer, using alloying elements which form solid solutions with tantalum (Ta) to expand and/or contract the lattice.

Using the present invention, seedlayer grain size is refined, and perpendicular anisotropy in magnetic media stacks which include a CoPt(Cr)(B) oxide containing magnetic data-storing granular media layer and/or a HCP-based underlayer is correspondingly increased since the subsequently deposited layers are formed over the enhanced, crystalline seedlayer. By incorporating the alloying element, the crystalline seedlayer minimizes the potential for lattice mismatch with HCP underlayers. The alloying element has the propensity to remain in the tantalum (Ta) lattice by forming a solid solution, thereby affecting the in-plane (a-lattice) parameter of tantalum (Ta). As a result of each of these improvements, the signal-to-noise ratio ("SNR") and $K_u$ for the PMR media stack are improved.

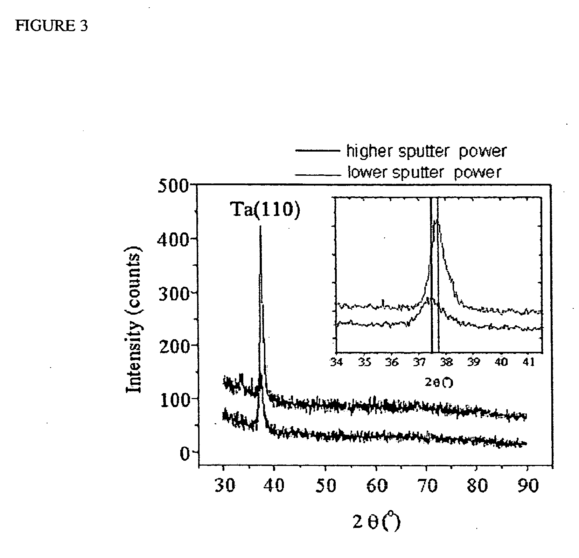

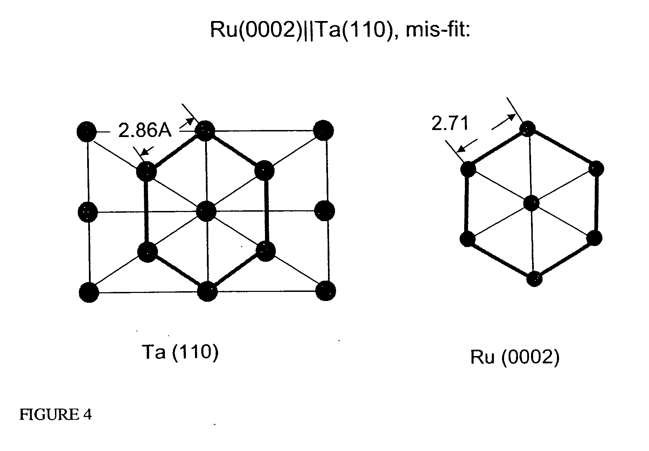

Figure 3 is an XRD spectrum of a 30 nanometer tantalum (Ta) film, which demonstrates that the alloying element is capable of enhancing the crystallinity of the HCP underlayer. As shown, when deposited on an amorphous substrate at room temperature, the tantalum (Ta) film is crystalline with the (110) planes of BCC tantalum (Ta) parallel to the film surface. Due to the symmetry of the (110) plane of the BCC tantalum (Ta), it is a very favorable surface for the growth of the ruthenium (Ru) films with the HCP (0002) planes parallel to the film surface. As depicted in Figure 3, the strong (0002) orientation in the ruthenium (Ru) or ruthenium (Ru) alloy based underlayer also promotes strong (0002) texture growth in the granular magnetic recording layer. In the Figure 4 example, with their respective crystallographic orientations, substantially pure tantalum (Ta) and ruthenium (Ru) films have a lattice mis-fit of approximately 5.6%. Alloying tantalum (Ta) with an alloying element which is soluble in tantalum (Ta) substantially eliminates this 5.6% mis-fit.

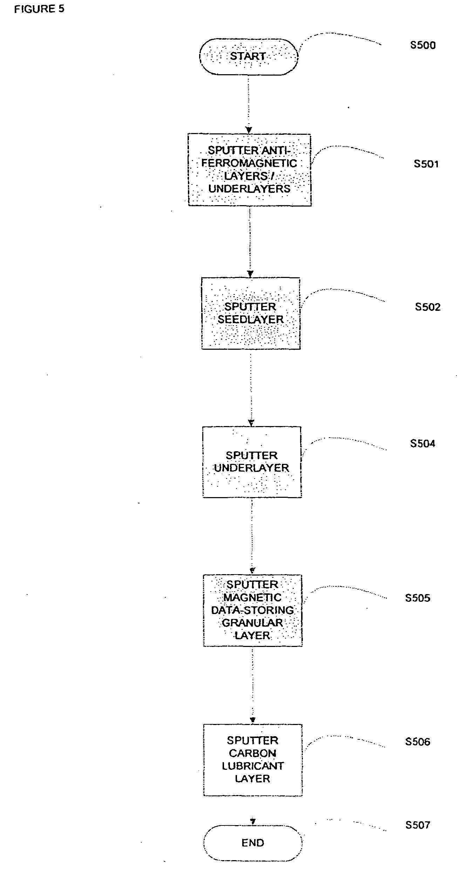

Figure 5 is a flowchart depicting a method for manufacturing a magnetic recording medium, according to a second embodiment of the present invention. Briefly, the method of manufacturing a magnetic recording medium includes the step of sputtering at least a first seedlayer over a substrate from a first sputter target, where the first sputter target is comprised of tantalum (Ta) and an alloying element. The method also includes the steps of sputtering at least a first underlayer over the first seedlayer from a second sputter target, and sputtering at least a first magnetic data-storing granular layer over the first underlayer from a third sputter target.

In more detail, the process begins (step S500), and certain layers, such as an anti-ferromagnetic layer, or underlayers, are deposited over the substrate (step S501). In alternate aspects of the present invention, step S501 is omitted. At least a first seedlayer is sputtered over a substrate from a first sputter target, where the first sputter target is comprised of tantalum (Ta) and an alloying element (step S502). As is readily understood by the above description of step S501, by sputtering the first seedlayer "over" the substrate, it is not necessary (although it is certainly contemplated) that the first seedlayer be in direct physical communication with the seedlayer, since additional layers may be deposited between the substrate and the first seedlayer.

According to one aspect associated with this arrangement, the solubility of the alloying element in a body centered cubic tantalum (Ta) phase does not exceed 10 atomic percent at room temperature, and the alloying element has a mass susceptibility of less than or equal to $1.5 \times 10^{-7}$ $\frac{m^3}{kg}$. Elements which meet these parameters and which could be used as the alloying element include, but are not limited to boron (B), carbon (C), aluminum (Al), silicon (Si), titanium (Ti), vanadium (V), manganese (Mn), chromium (Cr), zirconium (Zr), niobium (Nb), molybdenum (Mo), ytterbium (Yb), lutetium (Lu), hafnium (Hf), bismuth (Bi), and tungsten (W).

According to a second, alternate aspect associated with this arrangement, the alloying element is soluble in tantalum (Ta) at room temperature or at elevated temperatures, has a mass susceptibility of less than or equal to $1.5 \times 10^{-7}$ $\frac{m^3}{kg}$, and has an atomic radius smaller than 1.47Å. Elements which meet these parameters and which could be used as the alloying element include, but are not limited to boron (B), carbon (C), aluminum (Al), silicon (Si), chromium (Cr), ruthenium (Ru), rhodium (Rh), rhenium (Re), iridium (Ir) and platinum (Pt).

According to a third, alternate aspect also associated with this arrangement, the solubility of the alloying element in a body centered cubic tantalum (Ta) phase does not exceed 10 atomic percent at room temperature, and the alloying element has a mass susceptibility of less than or equal to $1.5 \times 10^{-7}$ $\frac{m^3}{kg}$, is soluble in tantalum (Ta) at temperatures higher than room temperature, and has an atomic radius smaller than 1.47Å. Elements which meet these parameters and which could be used as the alloying element include, but are not limited to boron (B), carbon (C), aluminum (Al), silicon(Si), platinum (Pt), and chromium (Cr).

At least a first underlayer is sputtered over the first seedlayer from a second sputter target (step S504). The first underlayer is comprised of ruthenium (Ru) or a ruthenium (Ru)-based alloy, although in alternate aspects other elements typically used in the art can be substituted for or used in conjunction with ruthenium (Ru), such as nickel (Ni) or titanium (Ti). The first underlayer is co-sputtered with the seedlayer, although seedlayer could also be sputtered separately.

At least a first magnetic data-storing granular layer is sputtered over the first underlayer from a third sputter target. (step S505). The first magnetic data-storing granular layer is co-sputtered with the seedlayer and/or the first underlayer, although the seedlayer and/or the first underlayer could also be sputtered separately from the first magnetic data-storing granular layer as well. An additional layer or layers, such as a carbon (C) overcoat and/or a lubricant layer, are sputtered over the first magnetic data-storing granular layer (step S506), and the process ends (step S507). In an alternate aspect, step S506 is omitted.

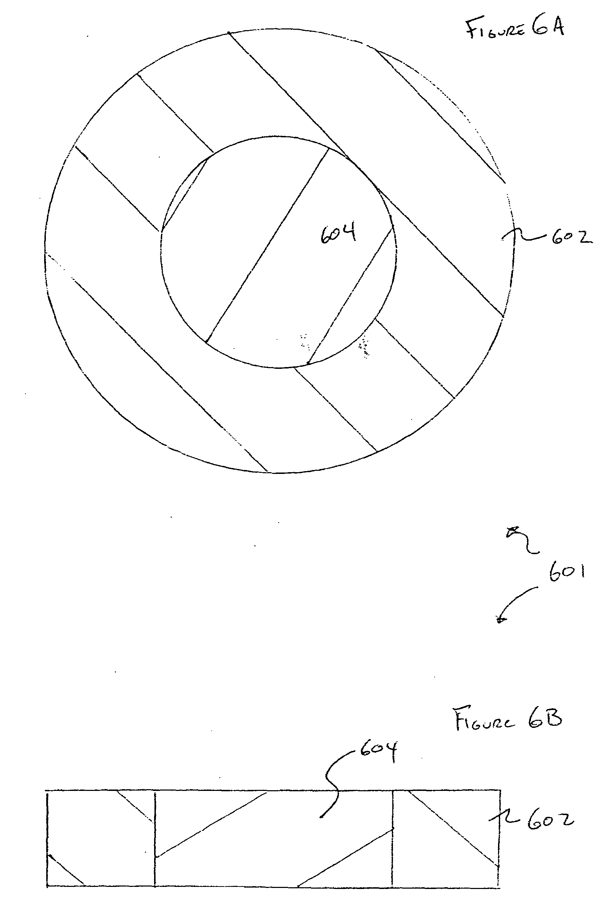

Figures 6A and 6B depict a top view and a cross-section view of a sputter target for a triatron configuration, respectively, according to a third embodiment of the present invention. Briefly, the sputter target for triatron configuration sputtering, includes a first region comprised of tantalum (Ta) and a second region comprised of an alloying element. As shown in Figure 6, triatron configuration co-sputtering uses a single sputter target with multiple independent composition regions. This single triatron sputter target would have an region comprised solely of tantalum (Ta) and a region comprised solely of $X_1$, where both regions would be co-sputtered simultaneously to deposit an Ta-$X_1$ thin film.

In more detail, sputter target 601 for triatron configuration sputtering includes first region 602 comprised of tantalum (Ta), and second region 604 comprised of an alloying element. Although first region 602 is illustrated as an outside annulus and second region 604 is illustrated as an inner circle, the respective positions can be reversed in alternate aspects, or different shapes or divisions could be used altogether.

According to one aspect, the solubility of the alloying element in a body centered cubic tantalum (Ta) phase does not exceed 10 atomic percent at room temperature, and the alloying element has a mass susceptibility of less than or equal to $1.5 \times 10^{-7} \frac{m^3}{kg}$, where possible alloying elements include (but are not limited to) boron (B), carbon (C), silicon (Si), aluminum (Al), titanium (Ti), vanadium (V), manganese (Mn), chromium (Cr), zirconium (Zr), niobium (Nb), molybdenum (Mo), ytterbium (Yb), lutetium (Lu), hafnium (Hf), bismuth (Bi), and tungsten (W).

According to a second aspect, the alloying element is soluble in tantalum (Ta) at room temperature or at elevated temperatures, has a mass susceptibility of less than or equal to $1.5 \times 10^{-7} \frac{m^3}{kg}$, and has an atomic radius smaller than 1.47Å, where possible alloying elements include (but are not limited to) boron (B), carbon (C), silicon (Si), aluminum (Al), chromium (Cr), ruthenium (Ru), rhodium (Rh), rhenium (Re), iridium (Ir) and platinum (Pt).

According to a third aspect, the solubility of the alloying element in a body centered cubic tantalum (Ta) phase does not exceed 10 atomic percent at room temperature, and the alloying element has a mass susceptibility of less than or equal to $1.5 \times 10^{-7} \frac{m^3}{kg}$, is soluble in tantalum (Ta) at temperatures higher than room temperature, and has an atomic radius smaller than 1.47Å, where possible alloying elements include (but are not limited to) boron (B), carbon (C), silicon (Si), aluminum (Al), and chromium (Cr).

According to an additional, non-depicted arrangement, the present invention is a sputter target, where the sputter target is comprised of tantalum (Ta) and an alloying element. The solubility of the alloying element in a body centered cubic tantalum (Ta) phase does not exceed 10 atomic percent at room temperature, and the alloying element has a mass susceptibility of less than or equal to $1.5 \times 10^{-7} \frac{m^3}{kg}$, where possible alloying elements include (but are not limited to) boron (B), carbon (C), titanium (Ti), vanadium (V), manganese (Mn), chromium (Cr), zirconium (Zr), niobium (Nb), molybdenum (Mo), ytterbium (Yb), lutetium (Lu), hafnium (Hf), bismuth (Bi), and tungsten (W). Alternatively, the alloying element is soluble in tantalum (Ta) at room temperature or at elevated temperatures, has a mass susceptibility of less than or equal to $1.5 \times 10^{-7} \frac{m^3}{kg}$, and has an atomic radius smaller than 1.47Å, where possible alloying elements include (but are not limited to) boron (B), carbon (C), chromium (Cr), ruthenium (Ru), rhodium (Rh), rhenium (Re), iridium (Ir) and platinum (Pt). Further alternatively, the solubility of the alloying element in a body centered cubic tantalum (Ta) phase does not exceed 10 atomic percent at room temperature, and the alloying element has a mass susceptibility of less than or equal to $1.5 \times 10^{-7} \frac{m^3}{kg}$, is soluble in tantalum (Ta) at temperatures higher than room temperature, and has an atomic radius smaller than 1.47Å, where possible elements include (but are not limited to boron (B), carbon (C), platinum (Pt), and chromium (Cr).

Based on concepts disclosed by the present invention, sputter targets of tantalum (Ta) based alloys can be used to produce crystalline tantalum (Ta) alloy based seedlayers with refined grain size, refining the grain size of the crystalline underlayer and promoting the subsequently epitaxially deposited granular magnetic layer. To its advantage, the present invention provides an additional approach to alloy the tantalum (Ta) alloy based seedlayer, reducing the lattice mis-fit between the tantalum (Ta) alloy based seedlayer and the underlayer, beneficially affecting the crystallinity of the underlayer. Each of these benefits enhances SNR and increases perpendicular anisotropy in the media stacks used for PMR.

The invention has been described with particular illustrative embodiments. It is to be understood that the invention is not limited to the above-described embodiments and that various changes and modifications may be made by those of ordinary skill in the art without departing from the spirit and scope of the invention.

**Claims**

1.  A magnetic recording medium, comprising:

    a substrate;
    a seedlayer deposited over said substrate, said seedlayer comprised of tantalum (Ta) and an alloying element;
    an underlayer deposited over said seedlayer; and
    a magnetic data-storing granular layer deposited over said underlayer,

wherein solubility of the alloying element in a body centered cubic tantalum (Ta) phase does not exceed 10 atomic percent at room temperature, and

wherein the alloying element has a mass susceptibility of less than or equal to $1.5 \times 10^{-7} \; \dfrac{m^3}{kg}$.

**2.** The magnetic recording medium according to Claim 2, wherein the alloying element is selected from the group consisting of boron (B), carbon (C), aluminum (Al), silicon (Si), titanium (Ti), vanadium (V), manganese (Mn), chromium (Cr), zirconium (Zr), niobium (Nb), molybdenum (Mo), ytterbium (Yb), lutetium (Lu), hafnium (Hf), bismuth (Bi), and tungsten (W).

**3.** A magnetic recording medium, comprising:

a substrate;
a seedlayer deposited over said substrate, said seedlayer comprised of tantalum (Ta) and an alloying element;
an underlayer deposited over said seedlayer; and
a magnetic data-storing granular layer deposited over said underlayer,
wherein the alloying element is soluble in tantalum (Ta) at room temperature or at elevated temperatures,

wherein the alloying element has a mass susceptibility of less than or equal to $1.5 \times 10^{-7} \; \dfrac{m^3}{kg}$, and

wherein the alloying element has an atomic radius smaller than 1.47Å.

**4.** The magnetic recording medium according to Claim 3, wherein the alloying element is selected from the group consisting of boron (B), carbon (C), aluminum (Al), silicon (Si), chromium (Cr), ruthenium (Ru), rhodium (Rh), rhenium (Re), iridium (Ir) and platinum (Pt).

**5.** The magnetic recording medium according to Claim 3, wherein said underlayer is comprised of ruthenium (Ru) or a ruthenium (Ru)-based alloy.

**6.** A magnetic recording medium, comprising:

a substrate;
a seedlayer deposited over said substrate, said seedlayer comprised of tantalum (Ta) and an alloying element;
an underlayer deposited over said seedlayer; and
a magnetic data-storing granular layer deposited over said underlayer,
wherein solubility of the alloying element in a body centered cubic tantalum (Ta) phase does not exceed 10 atomic percent at room temperature,

wherein the alloying element has a mass susceptibility of less than or equal to $1.5 \times 10^{-7} \; \dfrac{m^3}{kg}$,

wherein the alloying element is soluble in tantalum (Ta) at temperatures higher than room temperature, and
wherein the alloying element has an atomic radius smaller than 1.47Å.

**7.** The magnetic recording medium according to Claim 6, wherein the alloying element is selected from the group consisting of boron (B), carbon (C), aluminum (Al), silicon (Si), platinum (Pt) and chromium (Cr).

**8.** The magnetic recording medium according to Claim 6, wherein said underlayer is comprised of ruthenium (Ru) or a ruthenium (Ru)-based alloy.

**9.** A method of manufacturing a magnetic recording medium, comprising the steps of:

sputtering at least a first seedlayer over a substrate from a first sputter target, wherein the first sputter target is comprised of tantalum (Ta) and an alloying element, wherein solubility of the alloying element in a body centered cubic tantalum (Ta) phase does not exceed 10 atomic percent at room temperature, and wherein the alloying element has a mass susceptibility of less than or equal to $1.5 \times 10^{-7} \frac{m^3}{kg}$;

sputtering at least a first underlayer over the first seedlayer from a second sputter target; and
sputtering at least a first magnetic data-storing granular layer over the first underlayer from a third sputter target.

10. The method according to Claim 9, wherein the alloying element is selected from the group consisting of boron (B), carbon (C), aluminum (Al), silicon (Si), titanium (Ti), vanadium (V), manganese (Mn), chromium (Cr), zirconium (Zr), niobium (Nb), molybdenum (Mo), ytterbium (Yb), lutetium (Lu), hafnium (Hf), bismuth (Bi), and tungsten (W).

11. The method according to Claim 9, wherein the first seedlayer, the first underlayer and/or the first magnetic data-storing granular layer are sputtered using a co-sputtering assembly.

12. A method of manufacturing a magnetic recording medium, comprising the steps of:

sputtering at least a first seedlayer over a substrate from a first sputter target, wherein the first sputter target is comprised of tantalum (Ta) and an alloying element, wherein the alloying element is soluble in tantalum (Ta) at room temperature or at elevated temperatures, wherein the alloying element has a mass susceptibility of less than or equal to $1.5 \times 10^{-7} \frac{m^3}{kg}$, and wherein the alloying element has an atomic radius smaller than 1.47Å;

sputtering at least a first underlayer over the first seedlayer from a second sputter target; and
sputtering at least a first magnetic data-storing granular layer over the first underlayer from a third sputter target.

13. The method according to Claim 12, wherein the alloying element is selected from the group consisting of boron (B), carbon (C), aluminum (Al), silicon (Si), chromium (Cr), ruthenium (Ru), rhodium (Rh), rhenium (Re), iridium (Ir) and platinum (Pt).

14. The method according to Claim 12, wherein the first seedlayer, the first underlayer and/or the first magnetic data-storing granular layer are sputtered using a co-sputtering assembly.

15. The method according to Claim 12, wherein the first underlayer is comprised of ruthenium (Ru) or a ruthenium (Ru)-based alloy.

16. A method of manufacturing a magnetic recording medium, comprising the steps of:

sputtering at least a first seedlayer over a substrate from a first sputter target, wherein the first sputter target is comprised of tantalum (Ta) and an alloying element, wherein solubility of the alloying element in a body centered cubic tantalum (Ta) phase does not exceed 10 atomic percent at room temperature, wherein the alloying element has a mass susceptibility of less than or equal to $1.5 \times 10^{-7} \frac{m^3}{kg}$, wherein the alloying element is soluble in tantalum (Ta) at temperatures higher than room temperature, and wherein the alloying element has an atomic radius smaller than 1.47Å;
sputtering at least a first underlayer over the first seedlayer from a second sputter target; and
sputtering at least a first magnetic data-storing granular layer over the first underlayer from a third sputter target.

17. The method according to Claim 16, wherein the alloying element is selected from the group consisting of boron (B), carbon (C), aluminum (Al), silicon(Si), platinum (Pt), and chromium (Cr).

18. The method according to Claim 16, wherein the first seedlayer, the first underlayer and/or the first magnetic data-storing granular layer are sputtered using a co-sputtering assembly.

19. The method according to Claim 16, wherein the first underlayer is comprised of ruthenium (Ru) or a ruthenium (Ru)-based alloy.

20. A sputter target,
wherein the sputter target is comprised of tantalum (Ta) and an alloying element,
wherein solubility of the alloying element in a body centered cubic tantalum (Ta) phase does not exceed 10 atomic percent at room temperature, and

wherein the alloying element has a mass susceptibility of less than or equal to $1.5 \times 10^{-7} \ \frac{m^3}{kg}$ .

21. The sputter target according to Claim 20, wherein the alloying element is selected from the group consisting of boron (B), carbon (C), titanium (Ti), vanadium (V), manganese (Mn), chromium (Cr), zirconium (Zr), niobium (Nb), molybdenum (Mo), ytterbium (Yb), lutetium (Lu), hafnium (Hf), bismuth (Bi), and tungsten (W).

22. A sputter target,
wherein the sputter target is comprised of tantalum (Ta) and an alloying element,
wherein the alloying element is soluble in tantalum (Ta) at room temperature or at elevated temperatures,

wherein the alloying element has a mass susceptibility of less than or equal to $1.5 \times 10^{-7} \ \frac{m^3}{kg}$ , and

wherein the alloying element has an atomic radius smaller than 1.47Å.

23. The sputter target according to Claim 21, wherein the alloying element is selected from the group consisting of boron (B), carbon (C), chromium (Cr), ruthenium (Ru), rhodium (Rh), rhenium (Re), iridium (Ir) and platinum (Pt).

24. A sputter target,
wherein the sputter target is comprised of tantalum (Ta) and an alloying element,
wherein solubility of the alloying element in a body centered cubic tantalum (Ta) phase does not exceed 10 atomic percent at room temperature,

wherein the alloying element has a mass susceptibility of less than or equal to $1.5 \times 10^{-7} \ \frac{m^3}{kg}$ ,

wherein the alloying element is soluble in tantalum (Ta) at temperatures higher than room temperature, and
wherein the alloying element has an atomic radius smaller than 1.47Å.

25. The sputter target according to Claim 24, wherein the alloying element is selected from the group consisting of boron (B), carbon (C), and chromium (Cr).

26. A sputter target for triatron configuration sputtering, the sputter target comprising:

a first region comprised of tantalum (Ta); and
a second region comprised of an alloying element,
wherein solubility of the alloying element in a body centered cubic tantalum (Ta) phase does not exceed 10 atomic percent at room temperature, and

wherein the alloying element has a mass susceptibility of less than or equal to $1.5 \times 10^{-7} \ \frac{m^3}{kg}$ .

27. The sputter target according to Claim 26, wherein the alloying element is selected from the group consisting of boron (B), carbon (C), titanium (Ti), vanadium (V), manganese (Mn), chromium (Cr), zirconium (Zr), niobium (Nb), molybdenum (Mo), ytterbium (Yb), lutetium (Lu), hafnium (Hf), bismuth (Bi), and tungsten (W).

28. A sputter target for triatron configuration sputtering, the sputter target comprising:

a first region comprised of tantalum (Ta); and
a second region comprised of an alloying element,
wherein the alloying element is soluble in tantalum (Ta) at room temperature or at elevated temperatures,

wherein the alloying element has a mass susceptibility of less than or equal to $1.5 \times 10^{-7}$ $\frac{m^3}{kg}$, and

wherein the alloying element has an atomic radius smaller than 1.47Å.

29. The sputter target according to Claim 28, wherein the alloying element is selected from the group consisting of boron (B), carbon (C), chromium (Cr), ruthenium (Ru), rhodium (Rh), rhenium (Re), iridium (Ir) and platinum (Pt).

30. A sputter target for triatron configuration sputtering, the sputter target comprising:

a first region comprised of tantalum (Ta); and
a second region comprised of an alloying element,
wherein solubility of the alloying element in a body centered cubic tantalum (Ta) phase does not exceed 10 atomic percent at room temperature,

wherein the alloying element has a mass susceptibility of less than or equal to $1.5 \times 10^{-7}$ $\frac{m^3}{kg}$,

wherein the alloying element is soluble in tantalum (Ta) at temperatures higher than room temperature, and
wherein the alloying element has an atomic radius smaller than 1.47Å.

31. The sputter target according to Claim 30, wherein the alloying element is selected from the group consisting of boron (B), carbon (C), and chromium (Cr).

Figure 1
Prior Art

EP 1 783 748 A1

FIGURE 2

FIGURE 3

Ru(0002)||Ta(110), mis-fit:

Ta (110)                    Ru (0002)

FIGURE 4

FIGURE 5

START — S500

SPUTTER ANTI-
FERROMAGNETIC
LAYERS /
UNDERLAYERS — S501

SPUTTER
SEEDLAYER — S502

SPUTTER
UNDERLAYER — S504

SPUTTER
MAGNETIC
DATA-STORING
GRANULAR
LAYER — S505

SPUTTER
CARBON
LUBRICANT
LAYER — S506

END — S507

FIGURE 6A

604

602

601

FIGURE 6B

604

602

**EP 1 783 748 A1**

European Patent Office

**EUROPEAN SEARCH REPORT**

Application Number

EP 06 25 1476

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 293 969 A (FUJI) 19 March 2003 (2003-03-19) * page 4, line 58 - page 5, line 3 * * page 6, line 9 - line 10 * * page 6, line 18 - line 19 * * page 11, line 21 - line 28 * * page 11, line 39 - line 43 * ----- | 1-31 | INV. G11B5/73 G11B5/84 C23C14/34 |
| X | US 2004/197606 A1 (USUKI ET AL.) 7 October 2004 (2004-10-07) * paragraphs [0121] - [0123], [0127], [0128]; claim 9; figure 5B * ----- | 1-31 | |
| X | US 2005/142390 A1 (AJAN ET AL.) 30 June 2005 (2005-06-30) * paragraph [0051]; claims 1,3,5,9 * ----- | 1-10,12, 13, 15-17, 19-31 | |
| X | US 2004/234818 A1 (TANAHASHI ET AL.) 25 November 2004 (2004-11-25) * paragraph [0051] * * page 4; table 1 * * figure 1 * ----- | 1-10,12, 13, 15-17, 19-31 | TECHNICAL FIELDS SEARCHED (IPC) G11B C23C |
| X | US 2004/233565 A1 (ARAI ET AL.) 25 November 2004 (2004-11-25) * paragraph [0056]; figure 1; table 2 * ----- -/-- | 1-10,12, 13, 15-17, 19-31 | |

The present search report has been drawn up for all claims

| Place of search | Date of completion of the search | Examiner |
|---|---|---|
| The Hague | 20 July 2006 | Magrizos, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

22

European Patent Office

**EUROPEAN SEARCH REPORT**

Application Number

EP 06 25 1476

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/214049 A1 (YAMAMOTO ET AL.) 28 October 2004 (2004-10-28) <br><br> * paragraphs [0027], [0028], [0030], [0046]; figure 1 * <br> ----- | 1-10,12, 13, 15-17, 19-31 | |
| X | US 2004/202843 A1 (MORIWAKI ET AL.) 14 October 2004 (2004-10-14) <br><br> * paragraphs [0066], [0067]; claims 8,19,20 * <br> ----- | 1-10,12, 13, 15-17, 19-31 | |
| X | US 2004/038083 A1 (HIRAYAMA ET AL.) 26 February 2004 (2004-02-26) <br><br> * paragraphs [0049], [0066]; claim 3; figure 1 * <br> ----- | 1-10,12, 13, 15-17, 19-31 | |
| X | US 2001/016272 A1 (BIAN ET AL.) 23 August 2001 (2001-08-23) <br><br> * paragraphs [0020] - [0022]; figure 2; table 1 * <br> ----- | 1-10,12, 13, 15-17, 19-31 | **TECHNICAL FIELDS SEARCHED (IPC)** |
| X | US 6 878 460 B1 (HAILU ET AL.) 12 April 2005 (2005-04-12) <br><br> * column 5, line 55 - column 6, line 13 * <br> * column 6, line 49 - line 51 * <br> * column 6, line 66 - column 7, line 3 * <br> * column 8, line 4 - line 9; figure 2 * <br> ----- <br> -/-- | 1-10,12, 13, 15-17, 19-31 | |

The present search report has been drawn up for all claims

| Place of search | Date of completion of the search | Examiner |
|---|---|---|
| The Hague | 20 July 2006 | Magrizos, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 783 748 A1**

European Patent Office

**EUROPEAN SEARCH REPORT**

Application Number

EP 06 25 1476

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 740 397 B1 (LEE) 25 May 2004 (2004-05-25) <br><br> * column 6, line 16 - line 32 * <br> * column 9, line 8 - line 51; figure 3 * <br> ----- | 1-10,12, 13, 15-17, 19-31 | |
| X | US 5 849 386 A (LAL ET AL.) 15 December 1998 (1998-12-15) <br><br> * column 2, line 45 - column 3, line 4; figure 1 * <br> ----- | 1-10,12, 13, 15-17, 19-31 | |
| X | EP 1 378 893 A (HITACHI) 7 January 2004 (2004-01-07) <br><br> * page 5, line 36 - line 48; figure 1 * <br> ----- | 1-4,6,7, 9,10,12, 13,16, 17,20-31 | |
| X | US 2005/142389 A1 (HINOUE ET AL.) 30 June 2005 (2005-06-30) <br><br> * paragraph [0037]; claims 15,23 * <br> ----- | 1-4,6,7, 9,10,12, 13,16, 17,20-31 | TECHNICAL FIELDS SEARCHED (IPC) |
| X | US 2005/042479 A1 (TANAHASHI ET AL.) 24 February 2005 (2005-02-24) <br><br> * paragraph [0040] * <br> ----- | 1-4,6,7, 9,10,12, 13,16, 17,20-31 | |
| X | US 6 852 426 B1 (GIRT ET AL.) 8 February 2005 (2005-02-08) <br><br> * column 13, line 5 - line 10; claims 1,13 * <br> ----- <br> -/-- | 1-4,6,7, 9,10,12, 13,16, 17,20-31 | |

The present search report has been drawn up for all claims

| Place of search | Date of completion of the search | Examiner |
|---|---|---|
| The Hague | 20 July 2006 | Magrizos, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

24

# EP 1 783 748 A1

**European Patent Office**

**EUROPEAN SEARCH REPORT**

Application Number

EP 06 25 1476

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 828 036 B1 (MUNTEANU ET AL.) 7 December 2004 (2004-12-07)<br><br>* column 4, line 21 - line 47 *<br>* column 8, line 51 - column 10, line 2; figure 3 *<br>----- | 1-4,6,7, 9,10,12, 13,16, 17,20-31 | |
| X | US 6 777 112 B1 (GIRT ET AL.) 17 August 2004 (2004-08-17)<br><br>* column 10, line 33 - line 38; claims 1,8,9 *<br>----- | 1-4,6,7, 9,10,12, 13,16, 17,20-31 | |
| X | US 6 737 172 B1 (GIRT) 18 May 2004 (2004-05-18)<br><br>* column 12, line 29 - line 34; claims 1,12,13 *<br>----- | 1-4,6,7, 9,10,12, 13,16, 17,20-31 | TECHNICAL FIELDS SEARCHED (IPC) |
| X | US 5 700 593 A (OKUMURA ET AL.) 23 December 1997 (1997-12-23)<br><br>* column 8; table 3 *<br>* claim 1 *<br>----- | 1-4,6,7, 9,10,12, 13,16, 17,20-31 | |
| X | US 5 536 585 A (FUTAMOTO ET AL.) 16 July 1996 (1996-07-16)<br><br>* column 3, line 38 - line 40; claims 1,5 *<br>----- | 1-4,6,7, 9,10,12, 13,16, 17,20-31 | |

The present search report has been drawn up for all claims

| Place of search | Date of completion of the search | Examiner |
|---|---|---|
| The Hague | 20 July 2006 | Magrizos, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................................

& : member of the same patent family, corresponding document

EPO FORM 1503 03.82 (P04C01)

25

## ANNEX TO THE EUROPEAN SEARCH REPORT
## ON EUROPEAN PATENT APPLICATION NO.

EP 06 25 1476

This annex lists the patent family members relating to the patent documents cited in the above-mentioned European search report.
The members are as contained in the European Patent Office EDP file on
The European Patent Office is in no way liable for these particulars which are merely given for the purpose of information.

20-07-2006

| Patent document cited in search report | | Publication date | Patent family member(s) | | Publication date |
|---|---|---|---|---|---|
| EP 1293969 | A | 19-03-2003 | US | 2003134151 A1 | 17-07-2003 |
| US 2004197606 | A1 | 07-10-2004 | US | 2005008901 A1 | 13-01-2005 |
| US 2005142390 | A1 | 30-06-2005 | NONE | | |
| US 2004234818 | A1 | 25-11-2004 | JP | 2004348777 A | 09-12-2004 |
| US 2004233565 | A1 | 25-11-2004 | JP | 2004348849 A | 09-12-2004 |
| US 2004214049 | A1 | 28-10-2004 | JP | 2004326889 A | 18-11-2004 |
| US 2004202843 | A1 | 14-10-2004 | JP | 2003208710 A | 25-07-2003 |
| US 2004038083 | A1 | 26-02-2004 | CN | 1479276 A | 03-03-2004 |
| | | | JP | 2004146029 A | 20-05-2004 |
| | | | US | 2005227121 A1 | 13-10-2005 |
| US 2001016272 | A1 | 23-08-2001 | CN | 1309386 A | 22-08-2001 |
| | | | SG | 95623 A1 | 23-04-2003 |
| | | | US | 6586116 B1 | 01-07-2003 |
| | | | US | 2001024742 A1 | 27-09-2001 |
| | | | US | 2001018136 A1 | 30-08-2001 |
| US 6878460 | B1 | 12-04-2005 | NONE | | |
| US 6740397 | B1 | 25-05-2004 | NONE | | |
| US 5849386 | A | 15-12-1998 | NONE | | |
| EP 1378893 | A | 07-01-2004 | CN | 1467708 A | 14-01-2004 |
| | | | DE | 60302286 D1 | 22-12-2005 |
| | | | JP | 2004039152 A | 05-02-2004 |
| | | | US | 2004009375 A1 | 15-01-2004 |
| US 2005142389 | A1 | 30-06-2005 | CN | 1637867 A | 13-07-2005 |
| | | | JP | 2005190512 A | 14-07-2005 |
| US 2005042479 | A1 | 24-02-2005 | NONE | | |
| US 6852426 | B1 | 08-02-2005 | NONE | | |
| US 6828036 | B1 | 07-12-2004 | NONE | | |
| US 6777112 | B1 | 17-08-2004 | NONE | | |

EPO FORM P0459

For more details about this annex : see Official Journal of the European Patent Office, No. 12/82

**ANNEX TO THE EUROPEAN SEARCH REPORT
ON EUROPEAN PATENT APPLICATION NO.**

EP 06 25 1476

This annex lists the patent family members relating to the patent documents cited in the above-mentioned European search report.
The members are as contained in the European Patent Office EDP file on
The European Patent Office is in no way liable for these particulars which are merely given for the purpose of information.

20-07-2006

| Patent document cited in search report | Publication date | Patent family member(s) | Publication date |
|---|---|---|---|
| US 6737172 B1 | 18-05-2004 | NONE | |
| US 5700593 A | 23-12-1997 | JP 2834392 B2 | 09-12-1998 |
| | | JP 7073441 A | 17-03-1995 |
| US 5536585 A | 16-07-1996 | NONE | |

EPO FORM P0459

For more details about this annex : see Official Journal of the European Patent Office, No. 12/82